(19) Europäisches Patentamt
European Patent Office
Office européen des brevets

(11) **EP 1 064 723 B1**

(12) **EUROPEAN PATENT SPECIFICATION**

(45) Date of publication and mention
of the grant of the patent:
**08.09.2004 Bulletin 2004/37**

(51) Int Cl.⁷: $H03H\ 2/00$, $H03H\ 7/01$, $H03H\ 7/075$

(21) Application number: **99912529.7**

(22) Date of filing: **17.03.1999**

(86) International application number:
**PCT/US1999/005616**

(87) International publication number:
**WO 1999/052208 (14.10.1999 Gazette 1999/41)**

(54) **NARROW-BAND BAND-REJECT FILTER APPARATUS AND METHOD**

SCHMALBANDBANDSPERRFILTERANORDNUNG UND VERFAHREN

FILTRE ELIMINATEUR DE BANDE A BANDE ETROITE ET PROCEDE LE CONCERNANT

(84) Designated Contracting States:
**AT BE CH CY DE DK ES FI FR GB GR IE IT LI LU MC NL PT SE**

(30) Priority: **18.03.1998 US 40578**

(43) Date of publication of application:
**03.01.2001 Bulletin 2001/01**

(73) Proprietor: **CONDUCTUS, INC.**
**Sunnyvale, CA 94086 (US)**

(72) Inventors:
• **ZHANG, Dawei**
**Saratoga, CA 95070 (US)**
• **SZENTIRMAI, George**
**Palo Alto, CA 94303 (US)**
• **SHIH, Chien-Fu**
**Sunnyvale, CA 94086 (US)**
• **LIANG, Ji-Fuh**
**Sunnyvale, CA 94086 (US)**
• **LIANG, Guo-Chun**
**Cupertino, CA 95014 (US)**

(74) Representative: **König, Reimar**
**König-Szynka-von Renesse**
**Patentanwälte**
**Lohengrinstrasse 11**
**40549 Düsseldorf (DE)**

(56) References cited:
EP-A- 0 350 256          US-A- 3 656 162
US-A- 5 616 539

• CHALOUPKA: "HIGH-TEMPERATURE SUPERCONDUCTORS..." FREQUENZ., vol. 44, no. 5, May 1990, pages 141-144, XP000128587 BERLIN DE

**Description**

**Field of the Invention**

This invention generally relates to the field of band-reject filters. More particularly, it relates to the field of microwave band-reject filters. Still more particularly, it relates to the field of very-narrow band, thin-film, superconductive band-reject filters.

**Background**

Over the past decade, wireless telecommunications systems have become commonplace. One example is in the proliferation of cellular and mobile telephones, where the number of additional devices has pushed current radio technology to its limits within the assigned frequency ranges. More specifically, in this area of wireless telecommunications, each service provider is assigned a particular band (or region) of the electromagnetic spectrum. Within this band the provider's customers' communications have priority over all other signals. Accordingly, the service provider's equipment must be capable of transmitting and receiving signals within its allocated spectrum while filtering out those signals which are outside its allocated spectrum.

In the U.S. (and some other countries), each area has two cellular systems within the cellular spectrum to promote competition. The two systems may be designated as the "A" carrier and the "B" carrier. Continuing with the U.S. example, the "A" carrier transmits from its base station in the frequency ranges 869-880 and 890-891.5 MHz and receives in the ranges 824-835 and 845-846.5 MHz. The "B" carrier transmits in the frequency ranges 880-890 and 891.5-894 MHz and receives in the ranges 835-845 and 846.5-849 MHz. Ideally the "A" carrier receive filter combines a low-loss band pass filter in the range 824-846.5 MHz and a band stop filter in the range 835-845 MHz. The "B" carrier receive filters has a bandpass range of 835-849 MHz with a band-reject filter in the range 845-846.5 MHz. It will be appreciated that in order to maximize the use of the frequency range assigned to the carrier, both the bandpass filter and the band stop filter must have very sharp skirts. That is, the transition from nearly 100% transmission of the signal to essentially no transmission of the signal must be very steep. Additionally, to avoid cross-talk, the band-reject filter must produce a "notch" in the frequency spectrum which is very deep. In the "B" range in particular, the band stop filter must be a very narrow band.

Thin-film superconductive filters hold promise as ideal filters for communications base stations. Much effort has been directed toward developing filter designs in this area which maximize the advantages of superconductive filters within the limitations posed by the technology. Thin-film superconductive filters are generally fabricated by epitaxially depositing a layer of a high temperature superconductor on a crystalline substrate and then using lithographic methods for patterning the film to form inductive and capacitive elements. A number of patents and publications have heretofore addressed design considerations for superconductive filters. For example, Zhang, et al., "Frequency Transformation Apparatus and Method in Narrow-Band Filter Designs", PCT International Publication No. WO 96/12320, describes a very narrow band lumped-element microstrip filter with capacitively-loaded inductors. Also, Zhang, et al., "Microstrip Filters for Wireless Communications Using High-Temperature Superconducting Thin Films," Applied Superconductivity, Vol. 3, No. 7-10, 483-496 (1995), reviews a variety of design approaches to bandpass filters on small substrates.

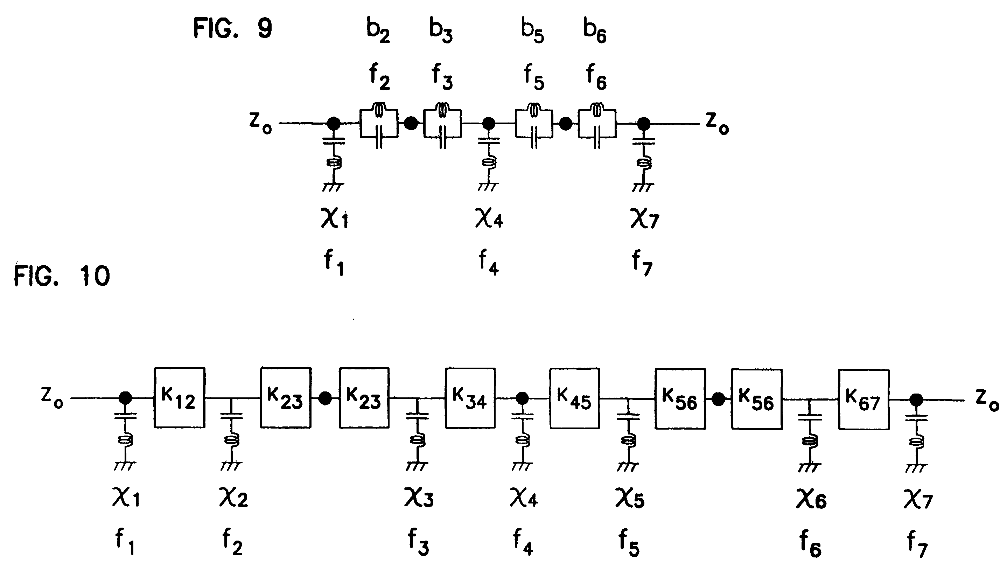

It is known to construct band-reject filters of a ladder circuit containing series branches of parallel-resonant circuits and. shunt resonators. Efforts to design superconductive thin-film band-reject or notch filters are more recent. One example is U.S. Patent No. 5,616,539 issued to Hey-Shipton et al., and titled "High Temperature Superconductor Lumped Element Band-Reject Filters". In this reference, resonators including serpentine inductors are used as the ground plane. The shunt structures are coupled to varying series inductors which are connected to the input and output lines (see Hey-Shipton Fig. 9). One disadvantage of the circuit used by Hey-Shipton is that the shunts are very large. As the bandwidth of the notch becomes smaller, the shunts then rapidly become unacceptably large.

Further filter structures are known e.g. from EP-A-0 350 256 and US-A-3 656 162.

Accordingly, there arises a need in the art to provide a band-reject filter having a narrow bandwidth with shunt structures sufficiently compact as to be realizable on a small substrate. The present invention addresses and overcomes the shortcomings of the prior art.

**Summary of the Invention**

The present invention provides a very-narrow band, thin-film, superconductive band-reject filter and a method of using and designing such a filter. While the present invention will be presented in connection with wireless telecommunications systems, and more particularly cellular and mobile telephone communication systems, such environment is only one in which preferred embodiments of the present invention may be employed. Other representative environments include satellite communications and military communications. Accordingly, the wireless communications environment should not be construed in a limiting manner.

In a preferred embodiment constructed according to the principles of the present invention, a seven pole notch filter is provided which is especially useful in connection with wireless technology. The filter may be constructed in either an MgO substrate or a LAO substrate. In the case of an LAO substrate, either a traditional lumped element inductor may be provided or a capacitively loaded inductor may be used. In the case of the MgO substrate, capacitively loaded inductors are preferred, however, other types of devices may used.

In preferred embodiments of the present invention, inductive, capacitive, and resistive electrical components are formed utilizing high temperature superconducting materials. The filter is formed from a plurality of impedance inverters connected in series, the inverters each having identical inductors and shunt capacitors in a pi-network. The impedance inverters series is connected at one end to an input pad and at the opposite end to a terminal pad. A plurality of identical resonators are capacitively coupled to the series impedance inverters. Each resonator rejects one particular frequency at its resonance, and the combined multiple rejection of all resonators forms the basis of a band-reject feature in the whole unwanted band.

While the invention will be described with respect to several preferred embodiment filters, and with respect to particular components, it will be understood that the invention is not to be construed as limited in any manner by such device with which the present invention is utilized. The principles of this invention apply to the field of microwave band-reject filters, and very-narrow band, thin-film, superconductive band-reject filters.

These and other variations of the invention will become apparent to those skilled in the art upon a more detailed description of the invention. Other advantages and feature which characterize the invention are pointed out with particularity in the claims annexed hereto and forming a part hereof. However, for a better understanding of the invention, reference should be had to the drawings which forms a further part hereof and to the accompanying descriptive matter, in which there is illustrated and described a preferred embodiment of the invention.

## Brief Description of the Drawings

Referring to the drawing, wherein like numerals represent like parts throughout the several views:

Figure 1 is a band-reject ladder circuit containing series branches of parallel-resonant circuits and shunt branches of series-resonant circuits.

Figure 2 is an equivalent circuit.

Figure 3 is the resulting circuit of applying the equivalent circuit of Fig. 2 to a series branch of the band-reject ladder circuit of Fig. 1.

Figure 4 is the resulting circuit of Fig. 3 after approximating jR by an inductor L and -jR by a capacitor C, wherein $2\pi f_0 L = R$ and $2\pi f_0 CR = 1$ (wherein $f_0$ is the center frequency of the band reject filter).

Figure 5 illustrates exact equivalent circuits used to modify the circuit of Fig. 4.

Figure 6 illustrates the new shunt branch of Fig. 4 after splitting the capacitor in the first shut branch and replacing it with the equivalent circuit illustrated in Fig. 5.

Figure 7 is a spurious frequency filter which results for frequencies relatively far away from the reject band.

Figure 8 are further equivalent circuits used to modify the circuit of Fig. 6.

Figure 9 illustrates a lumped element LC ladder network for a 7-pole elliptic function bandstop filter.

Figure 10 illustrates the resulting circuit after modifying the circuit illustrated in Fig. 9, wherein $K_{ij}$ is a microwave ideal device known as an impedance inverter.

Figure 11 illustrates the circuit in Fig. 10 after removing two cascading identical inverters.

Figure 12 illustrates the circuit in Fig. 11 after converting the series resonator to parallel resonators.

Figure 13a illustrates an impedance inverter in the circuit illustrated in Fig. 12.

Figure 13b illustrates the realization of the impedance inverter illustrated in Fig. 13a.

Figure 13c illustrates a admittance inverter in the circuit illustrated in Fig. 12.

Figure 13d illustrates the realization of the admittance inverter illustrated in Fig. 13c.

Figure 13e illustrates another realization of the impedance inverter illustrated in Fig. 13c.

Figure 14 illustrates the resulting circuit after the circuit of Fig. 12 is modified by the equivalent structures shown in Figs. 13a - 13e.

Figure 15 illustrates a notch filter circuit constructed in accordance with the principles of the present invention.

Figure 16 illustrates a layout of a notch filter on an MgO substrate using the circuit of Figure 15, a frequency transformed inductor.

Figure 17 illustrates a layout of a notch filter on an LAO substrate using the circuit of Figure 15, lumped element inductors and constructed in accordance with the principles of the present invention.

Figure 18 illustrates a layout of a notch filter on an LAO substrate using the circuit of Figure 15, a frequency transformed inductor, and constructed in accordance with the principles of the present invention.
Figure 19 illustrates an exemplary measured response of an HTS notch filter on an MgO substrate.

### Detailed Description of Illustrative Embodiments

One feature of the present invention is that the resulting filter provides for extremely sharp skirt rejection. As noted above, in order to maximize the use of the frequency range assigned to the carrier, both the bandpass filter and the band stop filter must have very sharp skirts. That is, the transition from nearly 100% transmission of the signal to essentially no transmission of the signal must be very steep. Additionally, to avoid cross-talk, the band-reject filter must produce a "notch" in the frequency spectrum which is very deep. Filters constructed in accordance with the principles of the present invention exhibit these desirable characteristics.

Another feature of the present invention is that devices constructed in accordance with the principles of the present invention do not require crossovers. Additionally, because of the uniformity of the inductors, for a given size substrate (e.g., a 2-inch substrate), a larger pole filter may be constructed thereby providing a sharper skirt. Still further, the principles of the present invention provide a circuit transformation methodology.

The notch filter according to the invention is characterized in what is presented in the appended claim 1. Further embodiments are disclosed in dependent claims 2 to 8. The method of making a notch filter according to the invention is in turn presented in independent claim 9.

The principles of this invention apply to the design and implementation of a seven pole notch filter which is especially useful in connection with wireless technology. The filter may be constructed in either an MGO substrate or a LAO substrate. A description of the preferred layouts will be deferred pending a discussion of the theory of operation and design methodology. Unless otherwise noted, the mathematical symbols used in the figures and equations in this specification are defined in the following Table 1:

TABLE I

| Symbol | Definition |
| --- | --- |
| BW | Bandwidth of the band-reject filter |
| $\omega$ | Angular frequency |
| L | Inductance |
| C | Capacitance |
| Z | Impedance |
| j | $\sqrt{-1}$ |
| $L_s$ | Inductance of a series inductor |
| $C_s$ | Capacitance of a series capacitor |
| $L_p$ | Inductance of a shunt inductor |
| $C_p$ | Capacitance of a shunt capacitor |
| $L_{sn}$ | Inductance of the $\pi$th series inductor |
| $C_{sn}$ | Capacitance of the $n$th series capacitor |
| $L_{pn}$ | Inductance of the $n$th shunt inductor |
| $C_m$ | Capacitance of the $n$th shunt capacitor |
| $C_o$, $C_a$, $C_b$ | Capacitances used in equivalent circuit calculations |
| $L_r$ | Inductance used in equivalent circuit calculations |
| $Z_o$ | Impedance of the filter |
| $b_i$ | Susceptance slope of the ith resonator (parallel resonator) |
| b | Slope parameter of a parallel resonator |
| $f_i$ | Resonance frequency of the ith resonator |
| $\chi_i$ | Reactance slope of the resonator (series resonator) |
| $K_{ij}$ | Coupling coefficient of the impedance inverter coupling the $i$th and $j$th series resonators |
| K | Coupling coefficient of an impedance inverter |
| $J_{10}$ | Couplind coefficient of the $i$th susceptance inverter |

A. Theory of Operation

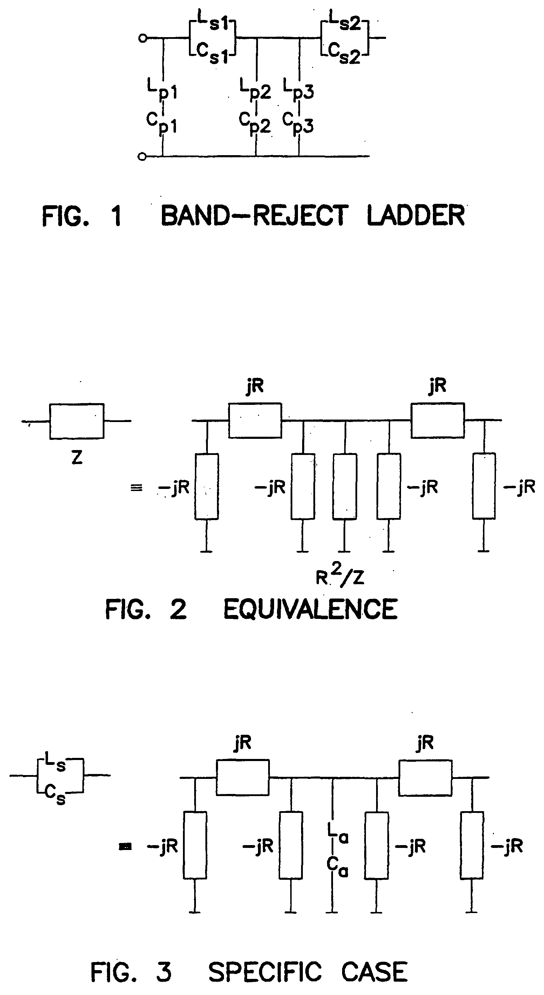

A very narrow band band-elimination filter, no matter how it is designed (Butterworth, Chebyshev, elliptic or in other manners), includes a ladder circuit containing series branches of parallel-resonant circuits and shunt branches of series-resonant circuits. The circuit in Fig. 1 illustrates this type of circuit, where:

$$L_{S1} \approx L_{S2} \approx \cdots \approx BW \qquad (1)$$

(e.g., the inductors $L_{sn}$ are proportional to the reject bandwidth), while

$$L_{P1} \approx L_{P2} \approx \cdots \approx 1/BW \qquad (2)$$

(e.g., the inductors $L_{pn}$ are proportional to the inverse bandwidth). Accordingly, the following relationship may be observed:

$$L_S / L_P \approx (BW)^2 \qquad (3)$$

In equation (3), if the bandwidth BW is 1% or less, then the ratio of the series inductors to those of the shunt inductors will exceed $10^4$ which is unacceptable.

If the frequency band of interest above the reject band is limited, as it usually is, then an approximate method may be used to eliminate this problem. The method is based on the (exact) equivalence shown in Fig. 2. In Fig. 2, R is an arbitrary resistance value. Therefore, jR and -jR represent constant (frequency-independent) reactances (positive and negative, respectively). Applying this equivalence to a series branch of the band-reject filter (i.e., substituting impedance Z with the parallel combination of $L_s$ and $L_s$) results in the specific case illustrated in Fig. 3, where:

$$L_a = R^2 = C_s; \qquad (4)$$

and

$$C_a = L_s / R^2 \qquad (5)$$

It will be appreciated to those of skill in the art that the value of R is usually selected to be equal to the terminating as a matter of convenience. However, selection of such a value for R is not necessary (if R is selected in that manner, the selection may save a few components if the filter degree is divisible by 4). Also, computing the series resonant circuit elements may be achieved by simply using the "DUAL" command of the S/FILSYN program manufactured by DGS Associate of Menlo Park, CA.

Naturatly, Z may contain two, series connected, parallel resonant circuits as well, in which case $R^2/Z$ will contain two series resonant circuits in parallel. Since a frequency-independent reactance does not exist, we approximate jR by an inductor L and -jR by a capacitor C such that:

$$2\pi f_0 L = R; \qquad (6)$$

and

$$Z\pi f_0 CR = 1 \qquad (7)$$

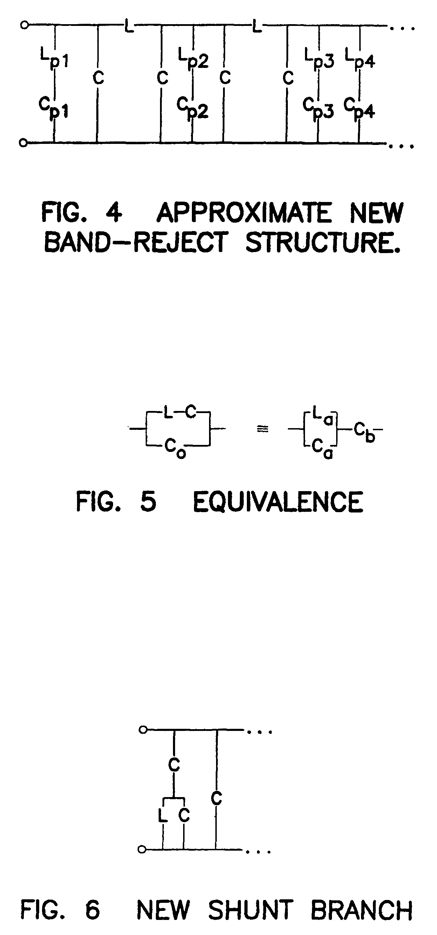

where $f_0$ is the center frequency of band reject filter. The resulting structure will now take the general from shown in Fig. 4. The pairs of parallel capacitors C may be combined into a single capacitor. Fig. 4 illustrates the approximate new band-reject structure in which all series $L_s$ are now equal and of magnitude:

$$L \approx 1$$

while all resonant circuit inductances are:

$$L_{p1} \approx L_{p2} \approx L_{p3} \approx \cdots \approx 1/(BW) \tag{8}$$

Consequently, the inductance ratio is reduced to about $1/(BW)$. For later reference, the same should be observed of the capacitance ratios.

Further modification of this structure may be made to improve this ratio to a greater extent. More specifically, the following exact equivalence for this purpose is illustrated in Fig. 5; where:

$$L_a = L(C/(C + C_0))^2 \tag{9}$$

$$C_a = C_0 (C + C_0)/C \tag{10}$$

$$C_b = C + C_0 \tag{11}$$

By way of example, the capacitor C in the first shunt branch of FIG. 4 may be split into two, with one of these being used together with the equivalence of FIG. 5 to obtain a new shunt branch as shown in FIG. 6. (The labels "L" and "C" in Fig. 6 denote generally an inductor and capacitor, respectively, and not devices with the same labels in other figures and equations.) Here, the value of the inductor in this circuit is selectable between very wide limits (i.e., due to the capacitance ratio being proportional to $1/(BW)$ as noted above. For instance, this operation can be used to make *all* inductors in the circuit, equal to a single common value. In fact, the S/FILSYN program has a command to perform this operation directly.

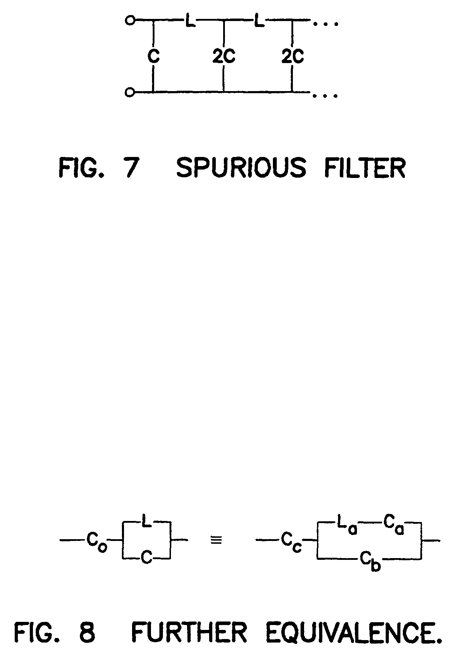

Since the frequency-independent reactances have been replaced by inductors and capacitors, the effect of this replacement must be determined in order to understand the modified overall filter performance. Clearly, if the reject band is very narrow, the overall performance in the reject band will be very close to the original. Only relatively for away from the reject band can any effects of this approximation be observed. On the other hand, far away from the reject band, the resulting circuit is simply as set forth in Fig. 7. It will be appreciated that this circuit is a simple "image-parameter" lowpass filter with characteristic impedance at zero frequency:

$$R_1 = \sqrt{(L/2C)} = R/\sqrt{2} \tag{12}$$

and a cut-off frequency:

$$f_r = \sqrt{2}/\sqrt{(LC)} = \sqrt{2}f_0 \tag{13}$$

which is about 40% above the reject band. Furthermore, the characteristic impedance at the band-reject frequency $f_0$ will be exactly equal to R, hence the filter is "matched" and will contribute nothing to the loss characteristics of the original band reject filter near the reject band. Elsewhere, there will be some deviation from the flat passband performance of the band-reject, but detailed numerical analysis shows that the deviation is at most about.5 dB from zero frequency up to about 35% beyond $f_0$.

Finally, for certain implementations, a structure is needed where both ends of all inductors must be grounded not directly, but through a capacitor. In such a case, Fig. 8 shows a further equivalence which may be useful. Since the right side of this equivalence is a reducible circuit, one of the values may be selected, say $C_a$ arbitrarily. After such selection, then the rest of the elements are computed as follows:

$$C_b = \sqrt{\left[(C_a/2)^2 + CC_a\right]} - C_a/2 \tag{14}$$

$$C_c = C_0(C_a + C_b)/(C_a + C_b - C_0); \tag{15}$$

and

$$L_a = LC(C_a+C_b)/(C_aC_b) \tag{16}$$

Substituting $C_b$ in the last equation, it can be rewritten, as:

$$L_a = L\left[\sqrt{(C/C_a + .25)} + .5\right]^2 \tag{17}$$

which shows that $L_a$ will always be greater that L. Hence, L must be selected to be lower in value than the desired final inductor value.

B. Design Methodology

The circuit in Figure 9 is a lumped-element LC ladder network for a 7-pole elliptic function bandstop filter. It contains both series and parallel resonators. Similar to the cases of microwave bandpass filters, an equivalent network containing only one type of resonator is usually required for practical realization by microwave structures.

A resonator is uniquely defined by two parameters. For microwave resonators, resonance frequency ($f_i$ for the $i$th resonator) and slope parameter are usually selected. A reactance slope parameter, $x_i$, is used for series resonators since it resonates at the frequency that impedance vanishes. The same is true for the susceptance slope parameter, $b_i$ for a parallel resonator.

The circuit of Fig. 9 can be converted to the circuit illustrated in Fig. 10 according to the equations set forth in Table II. That is, the parallel resonators ($f_i$, $b_i$) are replaced by a combination of series resonators ($f_i$, $x_i$) and impedance inverters ($K_{ij}$).

## TABLE II
### Equations for Converting Circuit in Fig. 9 to Circuit in Fig. 10

$$x_2 = b_2 {}^*K_{12}^2 \qquad\qquad x_2 = b_2 {}^*K^2$$

$$x_3 = b_3 {}^*K_{34}^2 \qquad\qquad x_3 = b_3 {}^*K^2$$

$$\frac{x_2}{x_3} = \frac{b_2}{b_3} \qquad\qquad \frac{x_2}{x_3} = \frac{b_2}{b_3}$$

$$K_{12} = K_{23} = K_{34}$$

$$x_5 = b_5 {}^*K_{45}^2 \qquad = K_{45} = K_{56} = k_{67} \qquad x_5 = b_5 {}^*K^2$$

$$\frac{x_5}{x_6} = \frac{b_5}{b_6} \qquad\qquad \frac{x_5}{x_6} = \frac{b_5}{b_6}$$

$$\longrightarrow$$

$$x_6 = b_6 {}^*K_{67}^2 \qquad\qquad x_6 = b_6 {}^*K^2$$

It will be appreciated that $K_{ij}$ is a microwave ideal device designated as an impedance inverter. In making the foregoing conversion, redundant elements are created. For example, impedance inverters which do not contribute to the selectivity of the filter, but make realization of the filter by only one type of resonator possible.

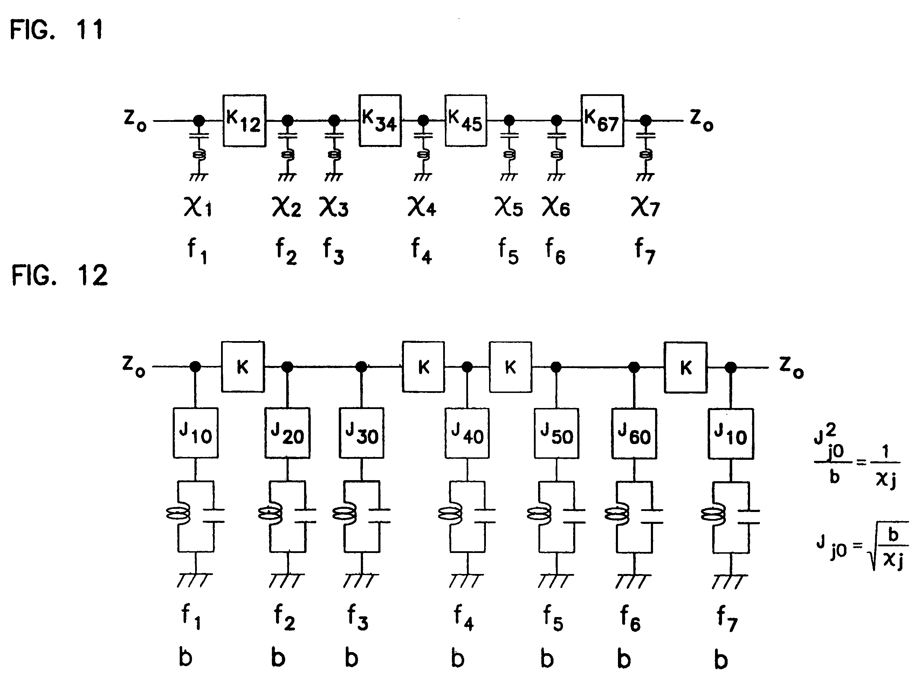

In view of the foregoing, the circuit in Fig. 10 is transformed to the circuit in Fig. 11 by eliminating the two cascading identical inverters. Thus, the effects of the pair of impedance inverters $K_{23}$ cancel each other out, and both impedance inverters may be eliminated. Similarly, the pair of impedance inverters $K_{56}$ may be eliminated. Further, a shunt series resonator directly connected to the signal path cannot be precisely realized by microstrip lumped elements. To solve this issue, admittance inverters, $J_{io}$, are introduced, as in the circuit illustrated in Fig 11, to convert the series resonator to parallel resonators. The equivalent parallel resonators have the same resonance frequencies ($f_i$) as the series resonators, but now have a susceptance slope parameter (*b*) instead of the reactance slope parameters ($\chi_i$). Again, those admittance inverters are redundant elements but are required to convert the equivalent network to a form that can be realized in microwave structures.

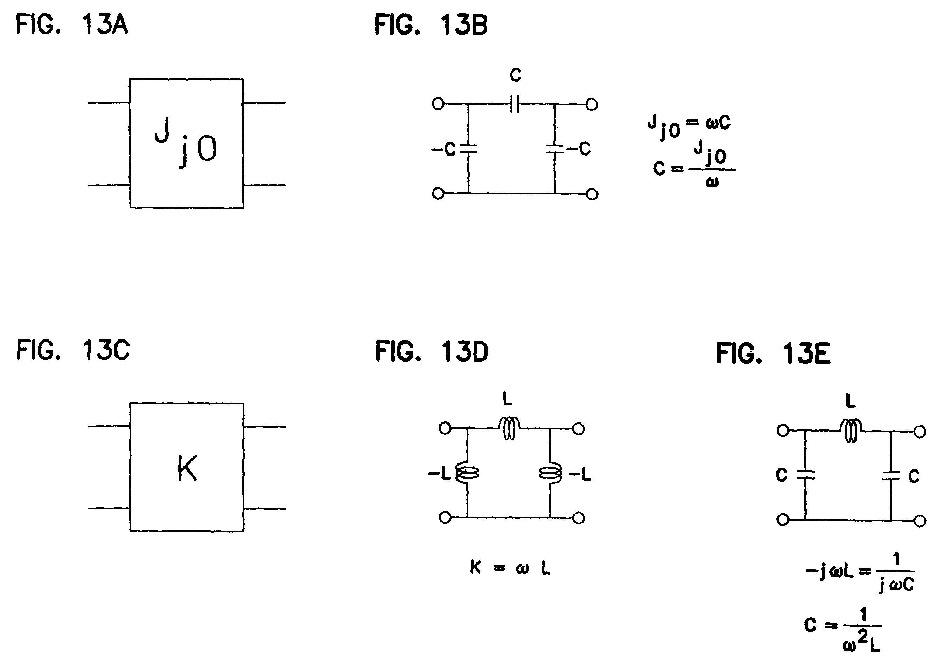

The networks illustrated in Figs. 13a through 13e are used to realize impedance inverters and admittance inverters found in the circuit of Fig. 12. In particular, the susceptance inverter in Fig. 13a may be realized by the network illustrated in Fig. 13b; the impedance inverter in Fig. 13c may be alternatively realized by the networks illustrated in Figs. 13d and 13e.

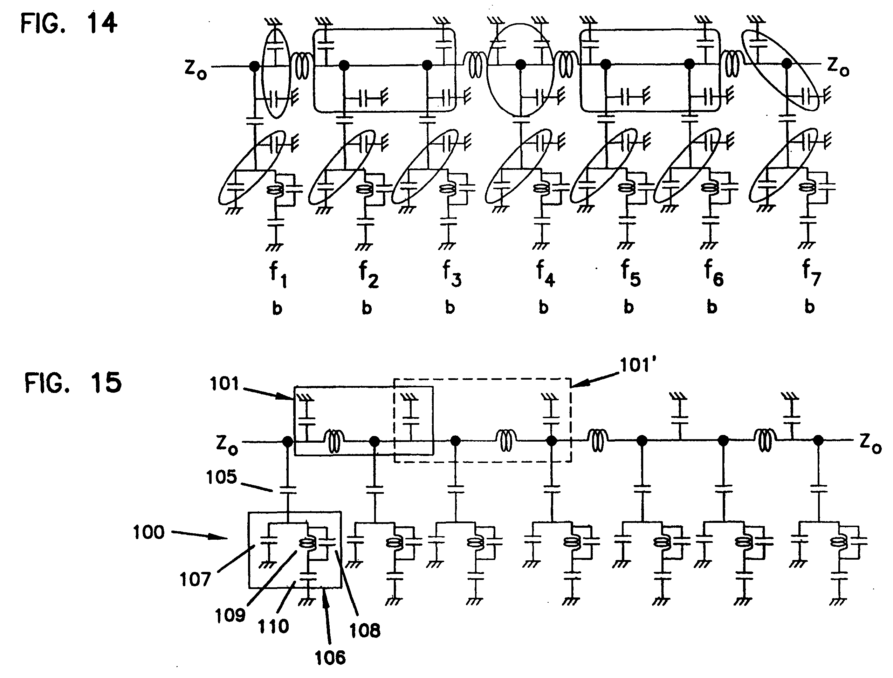

Next, the inverters and parallel resonators are replaced by the circuits described above resulting in the circuit illustrated in Fig. 14. Note that the capacitors that are grouped together in Fig. 14 by each slide-line loop are connected in parallel and may be replaced by a single capacitor. Finally, by combining the shunt capacitors that are connected in parallel, the circuit of Fig. 14 can be simplified, to the circuit of Fig. 15.

Referring to Fig. 15, the circuit is shown generally at 100. The impedance inverters are shown generally at 101 and are comprised of shunt capacitors 102, 103 and inductor 104. The coupling capacitor is illustrated at 105 and the resonator device illustrated at 106. Resonator device 106 is comprised of capacitors 107, 108 and 109. Also included in the resonator element 106 is inductor 110. The capacitively loaded inductor is comprised of inductor 109 and capacitor 108.

Impedance inverter 101 shares shunt capacitor 104 with the impedance inverter 101' shown in phantom. In turn, each of the impedance inverters along the transmission line share the shunt capacitor located therebetween.

C. Layout and Fabrication

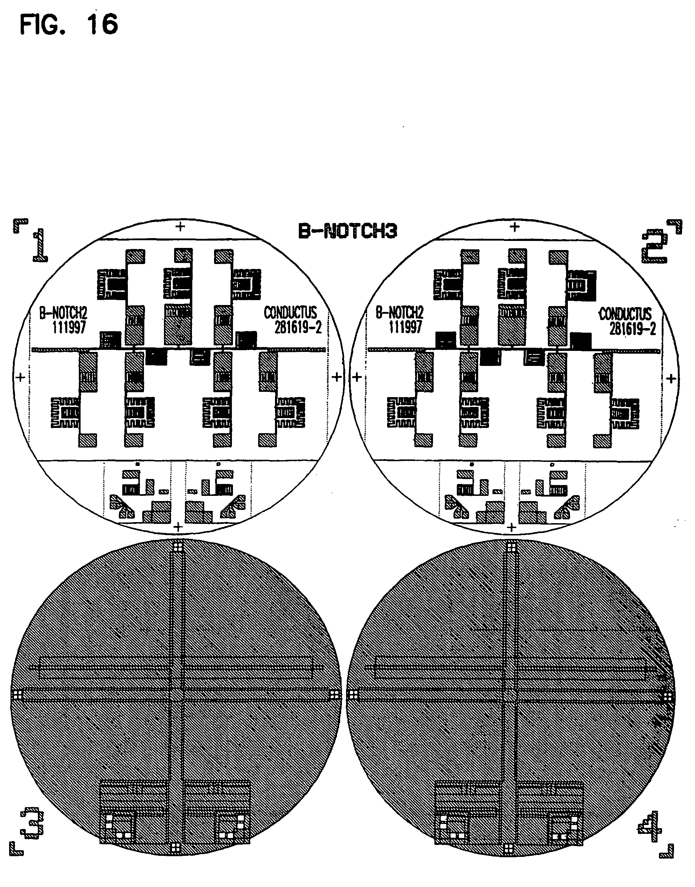

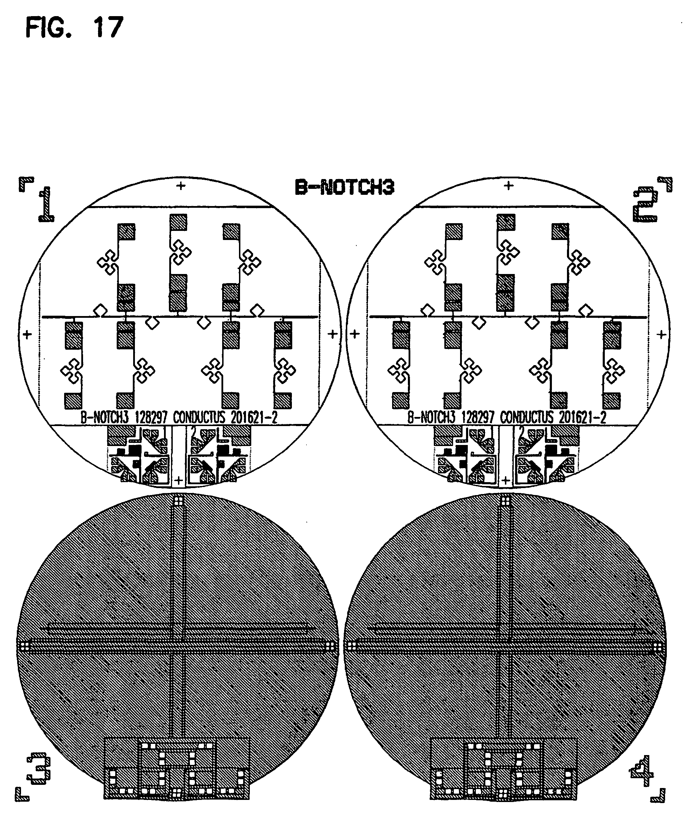

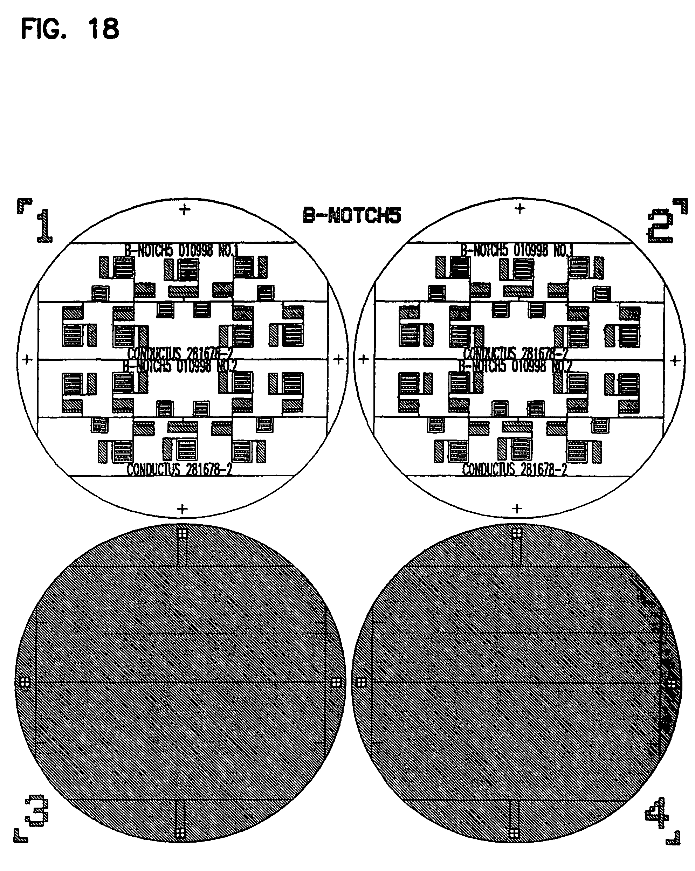

Figs. 16, 17, and 18 illustrate layouts of the circuit of Fig. 15 on superconductive substrates. More specifically, Fig. 16 illustrates a layout of a notch filter on an MgO substrate using frequency transformed inductors; Fig. 17 illustrates a layout of a notch filter on an LAO substrate using lumped element inductors; and Fig. 18 illustrates a layout of a notch filter on an LAO substrate using frequency transformed inductors. The resonator device 106 corresponds to the frequency-transformed inductors 606 and 806 in Figs. 16 and 18, respectively, and the lumped-element inductor 706 in Fig. 17; the impedance inverter 101 corresponds to the frequency-transformed inductors 601 and 806 in Figs. 16 and 18, respectively, and the lumped-element inductor 701 in Fig. 17; and the capacitor 105 corresponds to the capacitors 605, 705 and 805, respectively·

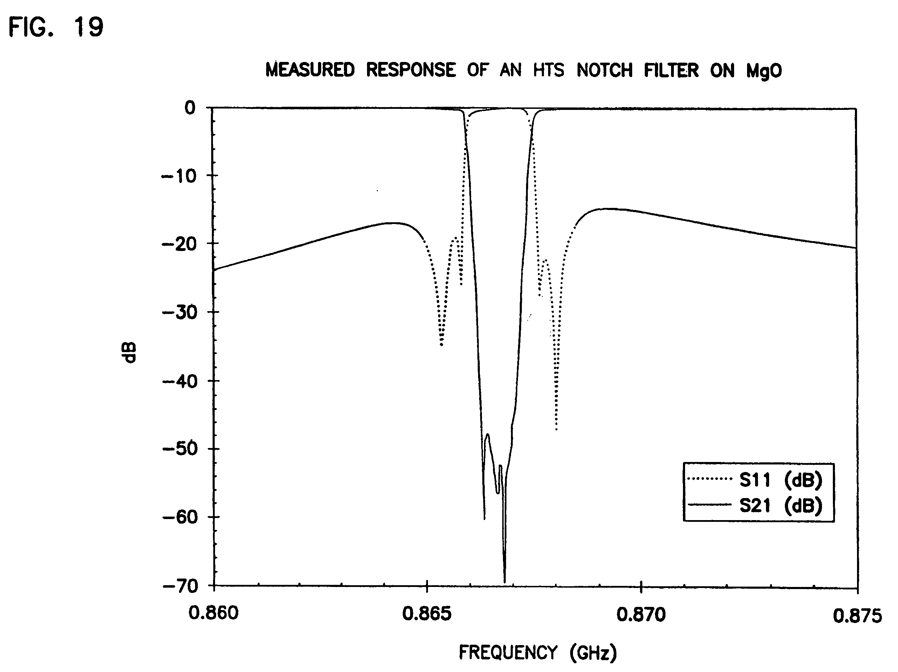

Fig. 19 illustrates the exemplary results from an experimentally measured 7 pole notch filter constructed in accordance with Fig.16. The solid line represents the transmission loss, and the dotted line represents the return loss through the filter.

It will be appreciated that the capacitive elements are the interdigitized devices 602, 608, 802 and 808 illustrated in Figs. 16 - 18. while the inductive elements are constructed using a half loop 604,609,804 and 809 and serpentine devices 704 and 709.

The filter devices of the invention are preferably constructed of materials capable of yielding a high circuit Q filter, preferably a circuit Q of at least 10,000 and more preferably a circuit Q of at least 40,000. Superconducting materials are suitable for high Q circuits. Superconductors include certain metals and metal alloys, such a niobium as well as certain perovskite oxides, such as $YBa_2Cu_3O_{7-8}$(YBCO). Methods of deposition of superconductors on substrates and of fabricating devices are well known in the art, and are similar to the methods used in the semiconductor industry.

In the case of high temperature oxide superconductors of the pervoskite type, deposition may be by any known method, including sputtering, laser ablation, chemical deposition or co-evaporation. The substrate is preferably a single crystal material that is lattice-matched to the superconductor. Intermediate buffer layets between the oxide superconductor and the substrate may be used to improve the quality of the film. Such buffer layers are known in the art, and are described,for example, in U.S. Patent No. 5,132,282 issued to Newman et al. Suitable dielectric substrates for oxide superconductors include sapphire (single crystal $Al_2O_3$) and lanthanum aluminate ($LaAlO_3$).

As an example circuit, all inductors are identical within the filter with 100 micron line width. All interdigital capacitor fingers are 50 micro wide. Equivalent inductance of this capacitively-loaded circuit is about 12 nanoHenries at 1.6 GHz. The whole filter structure may be fabricated on a MgO substrate with a dielectric constant of about 10. The substrate is 0.5 millimeter thick. Other substrates also used in this type of filters could be lanthanum aluminate and sapphire.

The YBCO is typically deposited on the substrate using reactive co-evaporation, but sputtering and laser ablation could also be used. A buffer layer may be used between the substrate and the YBCO layer, especially if sapphire is the substrate. Photolithography is used to pattern the filter structure.

While a particular embodiment of the invention has been described with respect to its application for wireless communications, it will be understood by those skilled in the art that other configurations that embody the principles of this invention and other applications therefor other than as described herein can be configured within the intent of this invention as defined in the appended Claims.

**Claims**

1. A notch fitter, comprising:

    a) a plurality of impedance inverter devices (101), wherein each of the impedance inverter devices includes a shunt capacitor and a first lump-element inductor connected in parallel with a capacitor, each impedance inverter has a first and second end, and the impedance inverters are connected to one another in series;
    b) a plurality of resonator devices (106);
    c) a plurality of coupling capacitors (105), wherein each coupling capacitor is connected between one of the resonator devices and the first end of one of the impedance inverters;

    the filter **characterized in that** each resonator device includes a capacitively-loaded inductor comprising a lump-element capacitor (108) in parallel with a second lump-element inductor (109) thus each resonator device rejecting one particular frequency at its resonance, whereby the combined rejection of the plurality of resonator devices establishes a band-reject area.

2. The notch filter of claim 1 further comprising:

    a) a substrate; and
    b) a conductive element fabricated on the substrate,

    wherein the plurality of impedance inverter devices (101), the plurality of resonator devices (106) and the plurality of coupling capacitors (105) are superconducting devices fabricated on the substrate and connected to the conductive element, wherein the lump-element capacitor is an interdigitized capacitive device, wherein the first inductor is a half-loop device, and wherein the second inductor is a serpentine device.

3. The filter of claim 2, wherein the superconductive devices are comprised of a high-temperature superconductor material.

4. The filter of claim 3, wherein the substrate is LAO or MgO.

5. The notch filter recited in claim 1, wherein each of the first lump-element inductors in each of the plurality of impedance inverter devices (101) has the same inductance.

6. The notch filter recited in claim 1, wherein the notch filter is a seven-pole filter.

7. The notch filter recited in claim 1, wherein the lump-element capacitor (108) in the resonator device (106) is an interdigital capacitor.

8. The notch filter recited in claim 1 or 7, wherein the second lump element inductor (109) is a half loop inductor.

9. A method of making a notch filter, comprising the steps of:

    (a) selecting a first plurality of inductors of identical inductance, a first plurality of shunt capacitors, and a plurality of load capacitors;
    (b) connecting a plurality of impedance inverter devices in series with one another, wherein each of the impedance inverter devices includes one of the first plurality of shunt capacitors, one of the first plurality of inductors, and one of the load capacitors, the connecting step including connecting the inductors in series with one another and connecting one of the load capacitors in parallel with one of the inductors;

(c) selecting a second plurality of inductors and a second plurality of capacitors, each of the second plurality of inductors being a lump-element inductor, each of the second plurality of capacitors being a lump-element capacitor;

(d) construct a plurality of resonator devices, each of the resonator devices including one of the second plurality of inductors and one of the second plurality of capacitors connected in parallel with one another;

(e) connecting one end of a coupling capacitor to each junction between an adjacent pair of the first plurality of inductors; and

connecting the other end of each of the coupling capacitors to a resonator device, wherein each resonator device rejects one particular frequency at its resonance, and whereby the combined rejection of the plurality of resonator devices establishes a band-reject area.

**10.** Method of claim 9, wherein step (c) includes selecting the capacitance of each one of the second plurality of capacitors so that each one of the resonator devices is a capacitively-loaded inductor having a positive susceptance slope.

**Patentansprüche**

**1.** Sperrfilter mit:

a) einer Vielzahl an Impedanz-Umrichter-Vorrichtungen (101), wobei jede der Impedanz-Umrichter-Vorrichtungen einen Parallelkondensator und eine erste, mit einem Kondensator parallel geschaltete, aus konzentrierten Elementen aufgebaute Induktivität, jeder der Impedanz-Umrichter weist ein erstes und ein zweites Ende auf und die Impedanz-Umrichter sind miteinander in Serie geschaltet;

b) einer Vielzahl an Resonator-Vorrichtungen (106);

c) einer Vielzahl an Koppelkondensatoren (105), wobei jeder der Koppelkondensatoren zwischen einer der Resonator-Vorrichtungen und dem ersten Ende von einem der Impedanz-Umrichter angeschlossen ist;

der Filter ist **dadurch gekennzeichnet, dass** jede Resonator-Vorrichtung eine kapazitiv geladene Induktivität umfasst, die einen aus konzentrierten Elementen aufgebauten Kondensator (108), parallel geschaltet zu einer zweiten, aus konzentrierten Elementen aufgebaute Induktivität (109), aufweist, so dass jede der Resonator-Vorrichtungen in ihrer Resonanz eine bestimmte Frequenz sperrt, wobei die kombinierte Sperrung der Vielzahl an Resonator-Vorrichtungen einen Bandsperrbereich erzeugt.

**2.** Der Sperrfilter nach Anspruch 1, weiterhin umfassend:

a) ein Substrat und

b) ein auf dem Substrat erzeugtes leitendes Element,

wobei die Vielzahl der Impedanz-Umrichter Vorrichtungen (101), die Vielzahl der Resonator-Vorrichtungen (106) und die Vielzahl der Koppelkondensatoren (105) auf dem Substrat erzeugte, supraleitende Vorrichtungen sind und mit dem leitenden Element verbunden sind, wobei der aus konzentrierten Elementen aufgebaute Kondensator eine interdigitalisierte, kapazitive Vorrichtung ist, wobei die erste Induktivität eine Halbschleifen- (half loop) Vorrichtung und die zweite Induktivität eine Schlangenlinien-(serpentine) Vorrichtung ist.

**3.** Der Filter nach Anspruch 2, wobei die supraleitenden Vorrichtungen ein Hochtemperatur-, supraleitendes Material umfassen.

**4.** Der Filter nach Anspruch 3, wobei das Substrat LAO oder MgO ist.

**5.** Der Sperrfilter nach Anspruch 1, wobei jede der ersten aus konzentrierten Elementen aufgebauten Induktivitäten in jeder aus der Vielzahl der Impedanz-Umrichter-Vorrichtungen (101) dieselbe Induktivität hat.

**6.** Der Sperrfilter nach Anspruch 1, wobei der Sperrfilter ein sieben-poliger Filter ist.

**7.** Der Sperrfilter nach Anspruch 1, wobei der aus konzentrierten Elementen, aufgebaute Kondensator (108) in der Resonator-Vorrichtung (106) ein interdigitaler Kondensator ist.

**8.** Der Sperrfilter nach Anspruch 1 oder 7, wobei die zweite, aus konzentrierten Elementen aufgebaute Induktivität (109) eine Halbschleifen- (half-loop) Induktivität ist.

**9.** Ein Verfahren zur Herstellung eines Sperrfilters umfasst die Schritte:

(a) Auswählen einer ersten Vielzahl von Induktivitäten identischer Induktivität, einer ersten Vielzahl von Parallelkondensatoren und einer Vielzahl von Belastungskondensatoren;

(b) Anschließen einer Vielzahl von Impedanz-Umrichter-Vorrichtungen in Serie miteinander, wobei jede der Impedanz-Umrichter-Vorrichtungen einen aus der ersten Vielzahl von Parallelkondensatoren, eine aus der ersten Vielzahl von Induktivitäten und einen der Belastungskondensatoren umfasst und der Anschlussschritt das Anschließen der Induktivitäten miteinander in Serie und das Anschließen eines der Belastungskondensatoren parallel mit einer der Induktivitäten umfasst;

(c) Auswählen einer zweiten Vielzahl von Induktivitäten und einer zweiten Vielzahl von Kondensatoren, wobei jede aus der zweiten Vielzahl von Induktivitäten eine aus konzentrierten Elementen aufgebaute Induktivität ist und jeder aus der zweiten Vielzahl von Kondensatoren ein aus konzentrierten Elementen aufgebauter Kondensator ist;

(d) Errichten einer Vielzahl von Resonator-Vorrichtungen, wobei jede der Resonator-Vorrichtungen eine aus der zweiten Vielzahl von Induktivitäten und einen aus der zweiten Vielzahl von Kondensatoren umfasst, die miteinander parallel geschaltet sind.

(e) Anschließen eines Endes eines Koppelkondensators mit jeder Anschlussstelle zwischen einem benachbarten Paar aus der ersten Vielzahl von Induktivitäten und

Anschließen des anderen Endes von jedem der Koppelkondensatoren an eine Resonator-Vorrichtung, wobei jede Resonator-Vorrichtung in ihrer Resonanz eine bestimmte Frequenz sperrt und wobei die kombinierte Sperrung der Vielzahl von Resonator-Vorrichtungen einen Bandsperrbereich erzeugt.

**10.** Verfahren nach Anspruch 9, wobei Schritt (c) die Auswahl der Kapazität von jedem der Kondensatoren aus der zweiten Vielzahl von Kondensatoren umfasst, so dass jede der Resonator-Vorrichtungen eine kapazitiv belastete Induktivität ist, die ein positives Suszeptanz-Gefälle aufweist.

**Revendications**

**1.** Filtre à bande étroite, comprenant :

a) une pluralité de dispositifs inverseurs d'impédance (101), dans laquelle chacun des dispositifs inverseurs d'impédance comprend un condensateur shunt et un premier inducteur en bloc ou à paramètre concentré connecté en parallèle avec le condensateur, chaque inverseur d'impédance ayant des première et seconde extrémités, les inverseurs d'impédance étant connectés l'un à l'autre en série ;
b) une pluralité de dispositifs résonateurs (106) ;
c) une pluralité de condensateurs de couplage (105) dans laquelle chaque condensateur de couplage est connecté entre un des dispositifs résonateurs et la première extrémité de l'un des inverseurs d'impédance ;

le filtre étant **caractérisé en ce que** chaque dispositif résonateur comprend un inducteur à charge capacitive comprenant un condensateur (108) en bloc ou à paramètre concentré en parallèle avec un second inducteur (109) en bloc ou à paramètre concentré, chaque dispositif résonateur rejectant une fréquence particulière à sa résonance, ce qui fait que la rejection combinée de la pluralité des dispositifs résonateurs établit un domaine de rejection de bande.

**2.** Filtre à bande étroite selon la revendication 1, comprenant en outre :

a) un substrat ; et

b) un élément conducteur fabriqué sur le substrat, dans lequel la pluralité des dispositifs inverseurs d'impédance (101), la pluralité des dispositifs résonateurs (106) et la pluralité des condensateurs de couplage (105) sont des dispositifs supraconducteurs fabriqués sur le substrat et connectés à l'élément conducteur, dans lequel le condensateur en bloc ou à paramètre concentré est un dispositif capacitif internumérisé, dans lequel le premier inducteur est un dispositif à demi-boucle et dans lequel le second inducteur est un dispositif en serpentine.

3. Filtre à bande étroite selon la revendication 2, dans lequel les dispositifs supraconducteurs sont constitués par un matériau supraconducteur à haute température.

4. Filtre à bande étroite selon la revendication 3, dans lequel le substrat est du LaO ou du MgO.

5. Filtre à bande étroite selon la revendication 1, dans lequel chacun des premiers inducteurs à paramètre concentré dans chacun de la pluralité de dispositifs (101) inverseurs d'impédance a la même inductance.

6. Filtre à bande étroite selon la revendication 1, dans lequel le filtre à bande étroite est un filtre à sept pôles.

7. Filtre à bande étroite selon la revendication 1, dans lequel le condensateur (108) à paramètre concentré dans le dispositif résonateur (106) est un condensateur intemumérisé.

8. Filtre à bande étroite selon la revendication 1 ou 7, dans lequel le second inducteur (109) à paramètre concentré est un inducteur à demi-boucle.

9. Procédé pour la fabrication d'un filtre à bande étroite, comprenant les étapes qui consistent :

a) à sélectionner une première pluralité d'inducteurs d'inductance identique, une première pluralité de condensateurs shunts et une pluralité de condensateurs de charge ;

b) à connecter une pluralité de dispositifs inverseurs d'impédance en série l'un avec l'autre, dans lequel chacun des dispositifs inverseurs d'impédance comprend un parmi la première pluralité de condensateurs shunts, un parmi la première pluralité d'inducteurs et un des condensateurs de charge, l'étape de connexion comprenant la connexion en série des inducteurs l'un avec l'autre et la connexion de l'un des condensateurs de charge en parallèle avec l'un des inducteurs ;

c) à sélectionner une seconde pluralité d'inducteurs et une seconde pluralité de condensateurs, chacun de la seconde pluralité d'inducteurs étant un inducteur en bloc ou à paramètre concentré ;

d) à construire une pluralité de dispositifs résonateurs, chacun des dispositifs résonateurs comprenant un parmi la seconde pluralité d'inducteurs et un parmi la seconde pluralité de condensateurs connectés en parallèle l'un avec l'autre ;

e) à connecter une extrémité d'un condensateur de couplage à chaque jonction située entre une paire adjacente de la première pluralité d'inducteurs ; et

à connecter l'autre extrémité de chacun des condensateurs de couplage à un dispositif résonateur, dans lequel chaque dispositif résonateur rejecte une fréquence particulière à sa résonance, ce qui fait que la rejection combinée de la pluralité des dispositifs résonateurs établit un domaine de rejection de bande.

10. Procédé selon la revendication 9, dans lequel l'étape (c) comprend la sélection du condensateur de chacun de la seconde pluralité de condensateurs, de manière à ce que chacun des dispositifs résonateurs soit un inducteur à charge capacitive ayant une pente de susceptance positive.

FIG. 1   BAND-REJECT LADDER

FIG. 2   EQUIVALENCE

FIG. 3   SPECIFIC CASE

FIG. 4   APPROXIMATE NEW
BAND-REJECT STRUCTURE.

FIG. 5   EQUIVALENCE

FIG. 6   NEW SHUNT BRANCH

## FIG. 7   SPURIOUS FILTER

## FIG. 8   FURTHER EQUIVALENCE.

FIG. 9

FIG. 10

**FIG. 11**

**FIG. 12**

$$\frac{J_{j0}^2}{b} = \frac{1}{x_j}$$

$$J_{j0} = \sqrt{\frac{b}{x_j}}$$

FIG. 13A

FIG. 13B

$J_{jo} = \omega C$

$C = \dfrac{J_{jo}}{\omega}$

FIG. 13C

FIG. 13D

$K = \omega L$

FIG. 13E

$-j\omega L = \dfrac{1}{j\omega C}$

$C = \dfrac{1}{\omega^2 L}$

FIG. 14

$f_1$  $f_2$  $f_3$  $f_4$  $f_5$  $f_6$  $f_7$

b   b   b   b   b   b   b

FIG. 15

EP 1 064 723 B1

# FIG. 16

B-NOTCH3

B-NOTCH2
111997

CONDUCTUS
281619-2

FIG. 17

FIG. 18

FIG. 19

MEASURED RESPONSE OF AN HTS NOTCH FILTER ON MgO

EP 1 064 723 B1